(19) Europäisches Patentamt
European Patent Office
Office européen des brevets

(11) **EP 4 576 299 A1**

(12) **EUROPEAN PATENT APPLICATION**

(43) Date of publication:
**25.06.2025 Bulletin 2025/26**

(21) Application number: **24221490.6**

(22) Date of filing: **19.12.2024**

(51) International Patent Classification (IPC):
**H01M 10/052** (2010.01)   **H01M 50/417** (2021.01)
**H01M 50/446** (2021.01)   **H01M 50/451** (2021.01)
**H01M 50/46** (2021.01)   **H01M 50/489** (2021.01)

(52) Cooperative Patent Classification (CPC):
**H01M 50/461; H01M 10/052; H01M 50/417;
H01M 50/446; H01M 50/451; H01M 50/489**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **20.12.2023 KR 20230186960**

(71) Applicants:
• **SK Innovation Co., Ltd.**
  **Seoul 03188 (KR)**
• **SK ie technology Co., Ltd.**
  **Jongno-gu**
  **Seoul**
  **03188 (KR)**

(72) Inventors:
• **KIM, Yun Bong**
  **Daejeon 34124 (KR)**
• **KIM, Dong Jae**
  **Daejeon 34124 (KR)**
• **OH, Eun Ji**
  **Daejeon 34124 (KR)**
• **JUNG, Hee Joon**
  **Daejeon 34124 (KR)**
• **CHO, Kyu Young**
  **Daejeon 34124 (KR)**

(74) Representative: **Prüfer & Partner mbB**
**Patentanwälte · Rechtsanwälte**
**Sohnckestraße 12**
**81479 München (DE)**

(54) **COMPOSITE SEPARATOR AND SECONDARY BATTERY USING THE SAME**

(57) The present disclosure relates to a composite separator including an adhesive layer and a secondary battery including the same. In the composite separator, the adhesive layer contains a particulate organic binder having a glass transition temperature of 60 to 80°C, and when the adhesive layers are brought into contact with each other, pressurized at a temperature of 50°C and a pressure of 1.7 MPa for 2 hours, and then peeled at a speed of 300 mm/min and an angle of 180°, blocking does not occur between the adhesive layers, and an adhesive strength to a positive electrode is about 0.0049 N/mm or more (5 gf/cm or more). The composite separator according to the present disclosure may have excellent adhesive strength to an electrode and may prevent a blocking phenomenon that occurs during winding.

FIG. 1

EP 4 576 299 A1

## Description

### TECHNICAL FIELD

The following disclosure relates to a composite separator and a secondary battery including the same.

### BACKGROUND

A separator manufactured using a porous substrate or a high heat-resistant separator including a porous substrate and a porous ceramic layer (or an inorganic particle layer) formed on one surface or both surfaces of the porous substrate according to the related art has insufficient adhesion to an electrode, and therefore, the separator and the electrode are often separated during a cell assembly process, resulting in distortion or deformation of an electrode assembly. In particular, in a case where the separator including the porous ceramic layer has insufficient adhesion to the electrode, a misalignment problem occurs between the electrode and the separator within a jelly roll during cell stacking.

When the stack cell battery with misalignment as described above is operated, a short circuit may occur between electrodes due to local resistance caused by misalignment or physical damage caused by continuous use, which may cause safety problems such as a fire.

Moreover, recently, in accordance with increases in capacity and size of the secondary battery for application in an electric vehicle and other large-sized device using the secondary battery, a separator in which a porous ceramic layer (inorganic particle layer) is formed on one surface or both surfaces of a porous substrate (ceramic coated separator (CCS)) has been used in a battery for a vehicle that has a large thickness, a high capacity, and a high heat-resistance. Accordingly, it has become more important to solve the above problems.

As a method for improving the adhesion between the separator and the electrode, there is a method of providing a separator including an adhesive layer formed on an upper portion thereof by applying a solution formed of an adhesive organic substance onto a surface of the separator and drying the solution. However, the adhesive organic layer results in deterioration of air permeability and makes it difficult to thin the film, and electrode adhesion is still poor.

Accordingly, when the separator is wound, a blocking phenomenon frequently occurs, which means that the adhesive organic layer is transferred to the opposite surface and detached. Due to this problem, there are various problems that need to be solved, such as a decrease in ionic conductivity of the separator and/or a thickness deviation that occurs during alignment of the electrode assembly, which impairs the performance of the battery.

[Related Art Document]

[Patent Document]

(Patent Document 1) Japanese Patent No. 4,414,165 (Publication date: March 3, 2005)

### SUMMARY

An embodiment of the present disclosure is directed to providing a composite separator including an adhesive layer formed on one surface or both surfaces of a porous separator and containing a particulate organic binder having specific physical properties, thereby providing a composite separator having excellent electrode adhesion while, at the same time, preventing a blocking phenomenon when the separator is wound. The porous separator may be a porous separator formed of a porous substrate or a porous separator including a porous substrate and a porous ceramic layer formed on one surface or both surfaces of the porous substrate.

Another embodiment of the present disclosure is directed to providing a composite separator that, when wound and then unwound and used as a separator, may maintain initial adhesive strength without a decrease in adhesive strength, does not cause blocking, and has excellent heat resistance.

Still another embodiment of the present disclosure is directed to providing a composite separator having excellent anti-blocking properties, which does not cause blocking between adhesive layers, between an adhesive layer and a ceramic layer, or between an adhesive layer and a porous substrate, of a wound roll, even when stored at a high temperature of 50 to 70°C as well as at room temperature of about 25°C during transport and storage of a wound separator.

Still another embodiment of the present disclosure is directed to providing a composite separator capable of resolving the problems in the related art in a case where blocking does not occur when adhesive layers are brought into contact with each other, pressurized at a temperature of 50°C and a pressure of 1.7 MPa for 2 hours, and then peeled at a speed of 300 mm/min and an angle of 180°.

Still another embodiment of the present disclosure is directed to providing a composite separator having uniform lithium ion conductivity over the entire area of the separator.

The composite separator and the secondary battery including the same in the present disclosure may be widely applied in an electric vehicle, a battery charging station, and other green technology fields such as solar power generation and wind power generation using batteries.

In addition, the composite separator and the secondary battery including the same in the present disclosure may be used in an eco-friendly electric vehicle, a hybrid vehicle, and other device using the secondary battery to prevent climate change by suppressing air pollution and greenhouse gas emissions.

As a result of conducting studies to provide a separator that has excellent adhesion to an electrode; does not cause blocking during storage and transport after being wound into a roll; and may maintain alignment well during battery assembly, the present inventors have found that all of the objects described above may be achieved when a particulate organic binder is contained, adhesive strength to a positive electrode satisfies a specific range, and blocking does not occur under specific conditions of adhesive strength between adhesive layers.

In one general aspect, a composite separator includes an adhesive layer formed on the outermost layer of at least one surface of a porous separator, wherein the adhesive layer comprises a particulate organic binder. In addition, when the adhesive layers are brought into contact with each other, pressurized at a temperature of 50°C and a pressure of 1.7 MPa for 2 hours, and then peeled at a speed of 300 mm/min and an angle of 180°, blocking does not occur between the adhesive layers, and an adhesive strength to a positive electrode is about 0.0049 N/mm or more (5 gf/cm or more).

In an embodiment, a content of the particulate organic binder in the adhesive layer may be 0.1 to 0.5 $g/m^2$, but is not limited thereto.

In an embodiment, an average particle diameter or D50 of the particulate organic binder may be 400 to 600 nm, but is not limited thereto.

In an embodiment, the porous separator may include, or optionally may be composed of, a porous substrate, or the porous substrate and a porous ceramic layer having inorganic particles formed on one surface or both surfaces of the porous substrate, but is not limited thereto.

In an embodiment, the particulate organic binder may be a core-shell particulate organic binder. The core-shell particulate organic binder may have a glass transition temperature of a whole core-shell particle that is higher than a glass transition temperature of a core when measured for the whole core-shell particle.

In an embodiment, the glass transition temperature of the core of the core-shell particulate organic binder may be 50 to 75°C, the glass transition temperature of the whole core-shell particle of the core-shell particulate organic binder may be 60 to 80°C, and the glass transition temperature of the whole core-shell particle may be higher than the glass transition temperature of the core.

In an embodiment, the core-shell particulate organic binder may be a particulate acrylic-based organic binder, and the shell may comprise a structure derived from an aromatic vinyl monomer.

In an embodiment, when electrodes are cut into pieces of 4 cm in width and 6 cm in length, and the four cut positive electrodes and four cut negative electrodes are alternately stacked on a surface of the composite separator, bonded at 80°C at 0.980665 $N/mm^2$ (10 $kgf/cm^2$) for 30 seconds, and then unfolded, all of the electrodes may not be detached.

In an embodiment, the inorganic particles of the porous ceramic layer may have an average particle diameter, D50 of 50 nm to 2 pm, but are not limited thereto.

In an embodiment, the inorganic particles of the porous ceramic layer may include first inorganic particles having an average particle diameter of 50 nm to 500 nm and second inorganic particles having an average particle diameter of 500 nm to 2,000 nm, but are not limited thereto. The average particle size of the first and the second inorganic particles may be different.

In an embodiment, the porous ceramic layer may have pores formed between the inorganic particles connected by the binder.

In an embodiment, the porous substrate may be a polyolefin-based porous film, but is not limited thereto.

In an embodiment, the composite separator may have a thermal shrinkage of 3% or less in both a machine direction and a width direction when measured at 150°C.

In another general aspect, a lithium secondary battery includes the composite separator according to an embodiment.

In an embodiment, when a cycle evaluation is performed by charging and discharging the lithium secondary battery 300 times at a discharge rate of 1 C and then measuring a discharge capacity to determine a degree of decrease in capacity compared to an initial capacity, a discharge capacity ratio calculated by the following equation may be 90% or more:

Discharge capacity ratio = (Battery capacity measured after 300 cycles)/Initial battery capacity.

In another general aspect, the composite separator as disclosed herein is used for winding the composite separator into a roll and subsequent storing and/or optionally transporting the wound separator. Optionally (in addition or alternative to an intermediate winding, storing and/or transporting), the composite separator may be used - directly or indirectly with intermediate steps - for manufacturing a secondary battery.

In a further aspect and optional further embodiments, the composite separator may be independently defined by a following constitution: the composite separator comprises an adhesive layer formed on the outermost layer of at least one surface of a porous separator, wherein the adhesive layer contains a particulate organic binder having a core-shell particulate organic binder structure. The core-shell particulate organic binder may have a glass transition temperature of the whole core-shell particle that is higher than a glass transition temperature of the core. The glass transition temperature of the core of the core-shell particulate organic binder may lie in a range of 50 to 75°C. The glass transition temperature of the whole core-shell particle of the core-shell particulate organic binder may lie in a range of 60 to 80°C. A content of the particulate organic binder in the adhesive layer ranges from 0.1 to 0.5 g/m. An average particle diameter of the particulate organic binder ranges from 400 to 600 nm.

Other features and aspects will be apparent from the following detailed description, the drawings, and the claims.

## BRIEF DESCRIPTION OF THE DRAWINGS

FIG. 1 is a cross-sectional view of a composite separator according to an embodiment of the present disclosure.
FIG. 2 is a cross-sectional view of a composite separator according to an embodiment of the present disclosure.
Fig. 3 is an SEM photograph of a 'pass' blocking evaluation of the present disclosure.

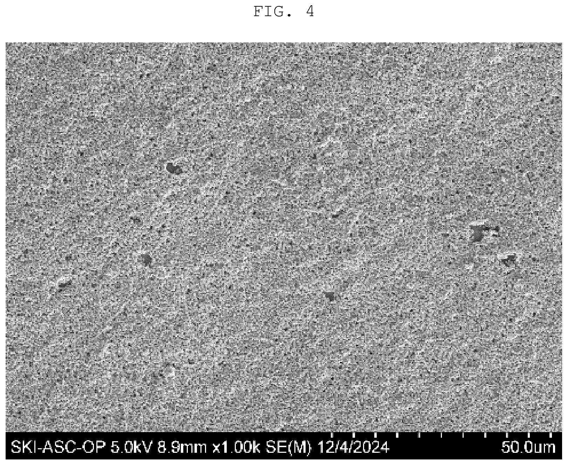

Fig. 4 is an SEM photograph of a 'fail' blocking evaluation of the present disclosure.

## DETAILED DESCRIPTION OF EMBODIMENTS

Hereinafter, the embodiments of the present disclosure will be described in detail. However, this is only illustrative, and the present disclosure is not limited to specific embodiments which are illustratively described by the present disclosure.

In addition, unless otherwise defined, all technical terms and scientific terms have the same meanings as commonly understood by those skilled in the art to which the present disclosure pertains. The terms used in the description of the present disclosure are merely used to describe specific embodiments, but are not intended to limit the present disclosure.

In addition, unless the context clearly indicates otherwise, singular forms used in the specification and the scope of the appended claims are intended to include plural forms.

In addition, unless explicitly described to the contrary, "comprising" any components will be understood to imply further inclusion of other components rather than the exclusion of any other components.

In addition, unless otherwise specifically defined, when one layer or member is disposed "on" another layer or member, it means not only a case where one layer or member is brought into direct contact with another member, but also a case where still another layer or member is present between the two layers or the two members.

In addition, the terms "about" and "substantially" are used in a numerical value or in the vicinity of the numerical value in the meanings mentioned when inherent manufacturing and material allowable errors are presented, and are used to prevent unconscious infringers from illegally using the accurate or absolute numbers disclosed in the present disclosure to help understanding of the present disclosure.

In the present disclosure, the term "average particle diameter" refers to "D50", and "D50" refers to a particle diameter of inorganic particles and particulate organic binder which corresponds to 50% of a volume-based integration fraction. The average particle diameter may be derived from particle size distribution results analyzed using S3500 available from Microtrac Retsch GmbH by collecting samples of the inorganic particles and particulate organic binder to be measured in accordance with ISO 13320-1 standard.

In the present disclosure, the term "glass transition temperature (Tg)" refers to a temperature range in which a glass transition occurs, and refers to a value measured using a dilatometer or a differential scanning calorimeter (DSC).

In the present disclosure, the term "composite separator" refers to a form including an adhesive layer formed on one surface or both surfaces of a porous separator, and the "porous separator" may be in the form of a porous substrate itself, or may be in the form of a porous substrate and a porous ceramic layer (a porous inorganic particle layer may also be used with the same meaning), which is formed on one surface or both surfaces of the porous substrate. The porous ceramic layer may have pores formed between inorganic particles connected and fixed by a binder.

In the present disclosure, "blocking" is measured by bringing two sheets of adhesive layers of a composite separator into contact with each other. Here, the "blocking" passes (meaning that blocking does not occur) when five randomly selected $50 \times 50 \, \mu m$ areas observed with a secondary electron microscope (SEM) show no peeling of the coating layer, or less than 2% of the area peeling of the coating layer. That is, in a case where an adhesive layer is formed on only one surface of the composite separator, blocking is evaluated by preparing two sheets of composite separators, stacking the composite separators to contact the adhesive layers with each other, pressurizing the stacked composite separators at a temperature of 50°C and a pressure of 1.7 MPa for 2 hours, and then peeling the adhesive layers at a speed of 300 mm/min and an angle of 180°. In addition, in a case where an adhesive layer is formed on both surfaces of the composite separator, blocking is evaluated by preparing two sheets of composite separators, selecting any one surface of the both surfaces, stacking the composite separators to contact the adhesive layers with each other at the selected surface, pressurizing the stacked composite separators at a temperature of 50°C and a pressure of 1.7 MPa for 2 hours, and then peeling the adhesive layers at a speed of 300 mm/min and an angle of 180°. In this case, the adhesive layers formed on the both surfaces may have the same composition. After peeling visual inspection and the above noted SEM inspection can be made.

Hereinafter, various embodiments of the present disclosure will be described.

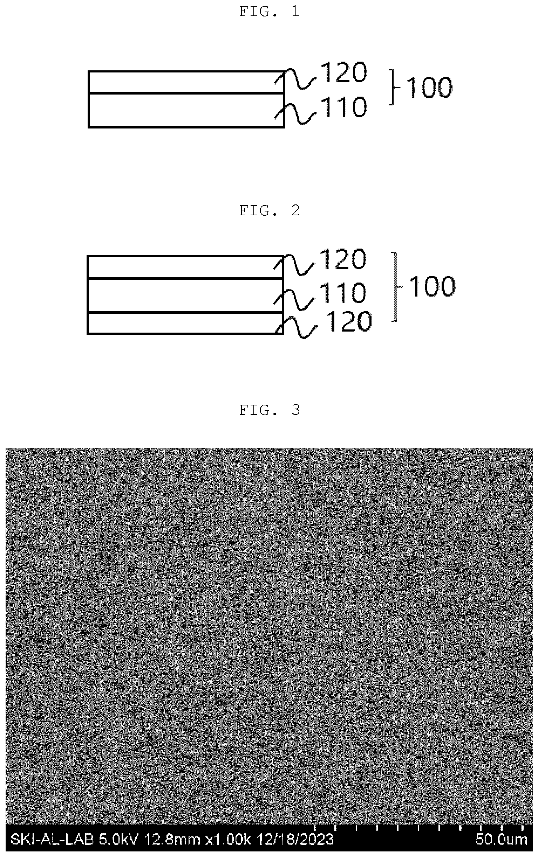

An aspect of the present disclosure provides a composite separator 100, as illustrated in FIGS. 1 and 2. The composite separator includes an adhesive layer 120 formed on one or both surfaces of a porous separator 110. This porous separator 110 comprises a porous substrate itself, or a porous substrate and a porous ceramic layer (which can also be referred to as a porous inorganic particle layer) that contains pores formed between inorganic particles that are connected and fixed by a binder. The adhesive layer comprises a particulate organic binder, and when the adhesive layers are brought into contact with each other, pressurized at a temperature of 50°C and a pressure of 1.7 MPa for 2 hours, and then peeled at a speed of 300 mm/min and an angle of 180°, blocking does not occur between the adhesive layers.

In addition, in the composite separator, an adhesive strength of the adhesive layer to a positive electrode may be about 0.0049 N/mm or more (5 gf/cm or more). The unit of 1 gram-force (gf)/cm is approximately equal to 0.00980665 Newtons (N)/cm and thus approximately equal to 0.000980665 Newtons (N)/mm.

Another aspect of the present disclosure may provide a composite separator including an adhesive layer formed on the outermost layer of at least one surface of a porous separator, wherein the adhesive layer comprises a particulate organic binder. When the adhesive layers are brought into contact with each other, pressurized at a temperature of 50°C and a pressure of 1.7 MPa for 2 hours, and then peeled at a speed of 300 mm/min and an angle of 180°, blocking does not occur between the adhesive layers, and an adhesive strength of the adhesive layer to a positive electrode is about 0.0049 N/mm or more (5 gf/cm or more). As the above physical properties are simultaneously satisfied, blocking may be prevented from occurring during winding of the composite separator into a roll and storage and transport of the wound separator, and the effects of maintaining alignment well during secondary battery assembly and improving capacity retention of the battery may be achieved at the same time.

In an embodiment, the adhesive layer may be an adhesive layer containing only the particulate organic binder.

In an embodiment, the adhesive layer may be stacked to face a negative electrode and a positive electrode of a lithium secondary battery. That is, when a lithium secondary battery is assembled, the adhesive layer is stacked on the negative electrode or the positive electrode to exhibit adhesion.

In an embodiment, areas of the porous substrate, the porous ceramic layer, and the adhesive layer may be substantially the same as or different from each other. For example, the porous ceramic layer may be formed on the porous substrate over the entire surface in the same area as that of the porous substrate, or may be formed with an area smaller than that of the porous substrate. In addition, the adhesive layer may be formed on the entire surface in the same area as that of the porous substrate or the porous ceramic layer, or may be formed in an area smaller than that of the porous substrate or the porous ceramic layer.

For example, the area of the formed adhesive layer may be 10 to 100% with respect to the total area of the porous ceramic layer or the porous substrate, and may be 99% or less, 95% or less, 90% or less, 80% or less, 70% or less, 60% or less, 50% or less, 40% or less, 30% or less, 20% or less, 10% or more, 20% or more, 50% or more, or between the above numerical values. For example, the area of the formed adhesive layer may be 10 to 90% or 20 to 80%, but is not limited as long as the object of the present disclosure may be achieved. Preferably, the area of the formed adhesive layer may be 80 to 100%.

In an embodiment, the porous ceramic layer may be formed to have a thickness of 1 to 50%, 1 to 45%, 1 to 40%, or 1 to 35% of the thickness of the entire composite separator. For example, the thickness of the porous ceramic layer may be 5 $\mu$m or less, 4 $\mu$m or less, 3 $\mu$m or less, 2 $\mu$m or less, 1 $\mu$m or less, 1 to 5 pm, or in any range between the above numerical values, but is not limited thereto.

In an embodiment, a coating amount of the adhesive layer may be 0.05 to 1.0 g/m$^2$, 0.1 to 0.8 g/m$^2$, 0.1 to 0.5 g/m$^2$, 0.1 to 0.3 g/m$^2$, or in any range between the above numerical values, but is not limited thereto.

In an embodiment, in the composite separator of the present disclosure, when the adhesive layers are brought into contact with each other, pressurized at a temperature of 50°C and a pressure of 1.7 MPa for 2 hours, and then peeled at a speed of 300 mm/min and an angle of 180°, blocking does not occur between the adhesive layers. In a case that the evaluation of blocking between the adhesive layers satisfies the condition by the above method, it was found that blocking would be prevented even under severe conditions that occur during storage and transport after winding the composite separator, thereby completing the present disclosure. For example, it can be confirmed that blocking does not occur even when the wound roll is stored at 50 to 70°C for 7 days. The occurrence of blocking is evaluated by the method described in a measurement method described below.

In an embodiment, an adhesive strength of the adhesive layer to a positive electrode may be 5 gf/cm or more, 6 gf/cm or more, 7 gf/cm or more, 8 gf/cm or more, 9 gf/cm or more, 10 gf/cm or more, 20 gf/cm or less, or in any range between the above numerical values, but is not limited thereto. For example, the adhesive strength of the adhesive layer to the positive electrode may be 5 to 20 gf/cm, 5 to 15 gf/cm, 5 to 12 gf/cm, or 5.2 to 10.2 gf/cm. A higher adhesive strength is preferable, but from the viewpoint of preventing blocking after winding and at the same time facilitating alignment during battery assembly, the adhesive strength to the positive electrode may be 5 to 15 gf/cm. Here, the unit of 1 gram-force (gf)/cm is approximately equal to 0.00980665 Newtons (N)/cm and thus approximately equal to 0.000980665 Newtons (N)/mm. When the above range is satisfied, it may be more advantageous in providing an effect in which blocking does not occur not only at room temperature but also at above room temperature (e.g., 50 to 70°C).

The positive electrode is not limited, and may be formed of a positive electrode slurry prepared by adding lithium-cobalt composite oxide ($LiCoO_2$), carbon black as a conductive agent, and polyvinylidene fluoride (PVdF) as a binder to N-methyl-2 pyrrolidone (NMP) as a solvent.

In an embodiment, an adhesive strength of the adhesive layer to a negative electrode may be 2 gf/cm or more, 3 gf/cm or more, 4 gf/cm or more, 5 gf/cm or more, 6 gf/cm or more, 7 gf/cm or more, 15 gf/cm or less, or in any range between the above numerical values, but is not limited thereto. The unit of 1 gram-force (gf)/cm is approximately equal to 0.00980665 Newtons (N)/cm and thus approximately equal to 0.000980665 Newtons (N)/mm.

The negative electrode is not limited, and may be formed of a negative electrode slurry prepared by adding artificial graphite, acrylic-based latex as a binder, and carboxymethyl cellulose as a thickener to water as a solvent.

The composite separator according to an embodiment of the present disclosure may have a thermal shrinkage of 3% or less, 2% or less, 1.5% or less, 1% or less, or 0.5% or less when measured after being left at 150°C for 1 hour, and as the composite separator has the above low thermal shrinkage, ignition or rupture due to abnormal phenomena such as rapid temperature rise within the lithium secondary battery may be prevented.

In addition, a lithium secondary battery including the composite separator according to an embodiment of the present disclosure may have a discharge capacity ratio of 90% or more, 95% or more, or 97% or more, the discharge capacity ratio being calculated by the following equation when a cycle evaluation is performed by charging and discharging the lithium secondary battery 300 times at a discharge rate of 1 C and then measuring a discharge capacity to determine a degree of decrease in capacity compared to an initial capacity based on an initial cell capacity of 1,800 mAh. For example, the discharge capacity ratio of the battery may be 90 to 99% or 92 to 97%.

Discharge capacity ratio = (Battery capacity measured after 300 cycles)/Initial battery capacity

In addition, when electrodes according to an embodiment of the present disclosure are cut into pieces of 4 cm in width and 6 cm in length, and the four cut positive electrodes and four cut negative electrodes are alternately stacked on a surface of the composite separator, heated and pressurized in a temperature atmosphere of 80°C at 0.980665 N/mm$^2$(10 kgf/cm$^2$) for 30 seconds, and grabbed the end of the outermost of an electrode/separator lamination and lifted vertically, there may be substantially no electrodes that fall.

In addition, in the present disclosure, when the composite separator including the porous separator and the adhesive layer is wound to 1,000 m or more and stored in an oven at each of 50°C and 70°C for 12 hours, and then the wound composite separator is unwound, there may be no inter-surface adhesion between the adhesive layers that are brought into contact with each other and no detachment of the ceramic layer.

Hereinafter, each component of the composite separator according to various embodiments of the present disclosure will be described by way of example.

[Porous Separator]

As an embodiment of the present disclosure, the porous separator may be formed of a porous substrate, or may include a porous substrate and a porous ceramic layer containing inorganic particles and being formed on one surface or both surfaces of a porous substrate.

The porous substrate may be a film, or a sheet formed of a polyolefin-based resin, and may be used without limitation as long as it is a microporous film adopted in the related art. Furthermore, the porous substrate is not particularly limited as long as it is a porous film that may be applied to a battery while having pores inside a non-woven fabric, paper, and a microporous film thereof or having pores with inorganic particles on a surface thereof.

The polyolefin-based resin may be a polyolefin-based resin alone or a mixture, and as a specific example, the polyolefin-based resin may be one or a mixture of two or more selected from polyethylene, polypropylene, and a copolymer thereof. In addition, the porous substrate may be manufactured using the polyolefin-based resin alone or using a polyolefin-based resin as a main component and additionally including inorganic particles or organic particles. In addition, the porous substrate may be used in a stacked form, for example, the porous substrate may be formed by constituting the polyolefin-based resin into multiple layers, and when the porous substrate is formed into multiple layers, one layer or all layers may contain inorganic particles and organic particles in the polyolefin-based resin.

A thickness of the porous substrate is not particularly limited, and may be 5 to 30 $\mu$m. As the porous substrate, a porous substrate formed by stretching may be mainly adopted, but is not limited thereto.

The porous ceramic layer may have pores formed between the inorganic particles connected by the binder.

The binder may be contained in an amount of 0.1 to 20 parts by weight, 0.1 to 10 parts by weight, or 1 to 5 parts by weight, with respect to 100 parts by weight of the inorganic particles, and may be used without limitation as long as it is a binder commonly used in the related art. As described above, as the binder is used in a significantly smaller amount than the inorganic particles, the porous ceramic layer has a structure in which inorganic particles are connected to each other and has pores formed by the inorganic particles being in surface contact with each other, thereby providing porosity.

Examples of the binder include various water-soluble and water-insoluble resins such as for example an acrylic-based resin such as polymethyl methacrylate and a copolymer thereof or polyacrylamide, an ester resin, polyamide, polyimide, a fluorine-based resin, polyacrylonitrile, polyethylene oxide, a cellulose-based resin, a polyvinyl alcohol-based resin, polyvinylpyrrolidone, an ethylene vinyl acetate copolymer, and cyanoethyl pullulan, and a mixture thereof, and the binder may be used in a form that is dissolved in a solvent or in the form of particles, but the embodiment is not limited thereto.

The inorganic particles of the porous ceramic layer may be used without limitation as long as they are commonly used in the related art. For example, the inorganic particles may be one or two or more inorganic particles selected from alumina, boehmite, aluminum hydroxide, titanium oxide, barium titanium oxide, magnesium oxide, magnesium hydroxide, silica, clay, and glass powder, but the embodiment are not limited thereto.

The inorganic particles may be contained in an amount of 70 wt% to 99.5 wt% with respect to 100 wt% of the total weight of the porous ceramic layer. For example, the inorganic particles may be contained in an amount of 70 wt% or more and 99 wt% or less, 70 wt% or more and 98 wt% or less, 80 wt% or more and 98 wt% or less, 85 wt% or more and 98 wt% or less, or 90 wt% or more and 98 wt% or less, but the embodiment is not limited thereto. When the porous ceramic layer contains the binder and the inorganic particles in the contents described above, the pores of the porous ceramic layer may be secured, and adhesion between the porous substrate and the porous ceramic layer or between the inorganic particles may be secured.

An average particle diameter (D50) of the inorganic particles is not limited, and may be 50 nm to 2 $\mu$m or 50 to 1,000 nm.

In an embodiment, the inorganic particles may be used by combining two types or two or more types of inorganic particles having different average particle diameters. For example, in the case of the two types of inorganic particles having different average particle diameters, an average particle diameter of first inorganic particles may be 50 nm to 500 nm or 100 nm to 400 nm, and an average particle diameter of second inorganic particles may be 500 nm to 2,000 nm or 600 nm to 1,000 nm.

In an embodiment, a thickness of the porous ceramic layer may be 5 $\mu$m or less, 4 $\mu$m or less, 3 $\mu$m or less, 2 $\mu$m or less, 1 $\mu$m or less, 1 to 5 pm, or in any range between the above numerical values, but the embodiment is not limited thereto.

[Adhesive Layer]

The adhesive layer of the present disclosure may be formed on the outermost layer of at least one surface of the porous separator.

In a case where the adhesive layer of the present disclosure contains a particulate organic binder. At the same time, in a case where, when the adhesive layers are brought into contact with each other, pressurized at a temperature of 50°C and a pressure of 1.7 MPa for 2 hours, and then peeled at a speed of 300 mm/min and an angle of 180°, blocking does not occur between the adhesive layers. The adhesive strength of the adhesive layer to the positive electrode satisfies about 0.0049 N/mm or more (5 gf/cm or more), the object of the present disclosure may be achieved more easily. The meaning that blocking does not occur means that blocking does not occur in the evaluation method described in <Blocking Evaluation Method> in the following physical property evaluation methods.

The composite separator including the adhesive layer according to the present disclosure may achieve an effect in which blocking does not occur between the adhesive layers even at a high temperature. In addition, the composite separator may prevent alignment defects during battery assembly and, at the same time, may provide an excellent capacity retention rate of the battery.

There are no limitations on the reason for the particulate organic binder exhibiting the blocking properties, and the particulate organic binder may be used without limitation in consideration of the adhesive strength and blocking properties. For example, the particulate organic binder may be a core-shell particulate organic binder, in which a glass transition temperature of a whole core-shell particle may be higher than a glass transition temperature of a core portion. In addition, the size or particle distribution, the degree of crosslinking, the type or content of the comonomer, and the like of the core-shell particles may affect the physical properties, and the blocking properties exhibited under the above conditions.

The core-shell particulate organic binder refers to a form composed of a particulate core and a shell surrounding a surface of the particulate core.

As an example, the core-shell particulate organic binder may have a glass transition temperature measured for a whole core-shell particle of 60°C or higher, 80°C or lower, or any value between the above numerical values. For example, the glass transition temperature may be 60 to 80°C, 65 to 80°C, 69 to 78°C, or 70 to 78°C. The core-shell particulate binder may be a particulate acrylic-based binder, a particulate binder prepared by controlling the degree of crosslinking within a specific range while having the above glass transition temperature, or a particulate acrylic-based organic binder prepared to have the above properties by a method of modifying a surface of an organic binder particle using a specific modifier, but the embodiment is not limited as long as it is a particulate organic binder satisfying the physical properties of the present disclosure.

As an example, the core-shell particulate organic binder may have a glass transition temperature of a core of 50°C or higher, 75°C or lower, or any value between the above numerical values. For example, the glass transition temperature of the core of the core-shell particulate organic binder may be 50 to 75°C, 55 to 70°C, 60 to 70°C, 62 to 70°C, or 65 to 70°C, and the glass transition temperature of the whole core-shell particle may be 60 to 80°C., The core-shell particulate organic binder may be a particulate acrylic-based organic binder having a glass transition temperature of a whole core-shell particle that is higher than a glass transition temperature of a core. As described above, as the glass transition temperature of the whole core-shell particle including the core and the shell is set to have a glass transition temperature that is higher than the glass transition temperature of the core, the desired anti-blocking properties and adhesion may be exhibited, and at the same time, an excellent battery capacity retention rate can be provided.

In an embodiment, the core-shell particulate organic binder may have a content ratio of the core : the shell of 60 to 99:40 to 1 wt% or 60 to 90:40 to 10 wt%, but is not limited thereto, and within the above range, more excellent effects of electrode adhesive strength and anti-blocking properties may be provided.

In an embodiment, the core-shell particulate organic binder may be in the form of polymer particles that may be prepared by emulsion polymerization or suspension polymerization, and may be in the form of non-crosslinked or crosslinked particles.

The core-shell particulate organic binder may be acrylic-based organic particles, and the shell may comprise a structure derived from an aromatic vinyl monomer.

The acrylic-based organic particles may be formed of an acrylic-based polymer, and examples of the acrylic-based polymer include polymers obtained by polymerizing one or more monomers selected from C1-C10 alkyl (meth) acrylates; (meth)acrylates; (meth)acrylonitriles such as acrylonitrile and methacrylonitrile; aromatic vinyl monomers such as styrene, α-methylstyrene, styrenesulfonic acid, butoxystyrene, and vinylnaphthalene; and maleimide derivatives such as maleimide and phenylmaleimide. The acrylic-based polymer is not limited thereto and may be produced by mixing various monomers so that a glass transition temperature is 60 to 80°C.

For example, in the case of the core-shell particulate organic binder, the core may be an acrylic-based copolymer copolymerized with a C1-C10 alkyl (meth)acrylate, a (meth)acrylate, and a (meth)acrylonitrile, and the glass transition temperature may be lowered by controlling a content of the C1-C10 alkyl (meth)acrylate. The (meth)acrylate refers to an acrylate or a methacrylate. Specific examples thereof include, but are not limited to, methyl acrylate, methyl methacrylate, ethyl acrylate, ethyl methacrylate, butylacrylate, and butyl methacrylate. The shell may be an acrylic-based copolymer copolymerized using an aromatic vinyl monomer such as styrene and a monomer mixture including a (meth)acrylate, and the glass transition temperature may be increased by controlling a content of the aromatic vinyl monomer. The (meth) acrylate refers to an acrylate or a methacrylate.

In an embodiment, the particulate organic binder may also have a swelling ratio of 300 to 500% or 320 to 490% according to the following Equation 1 when immersed in an electrolyte. The above range is more preferable but the embodiment is not limited thereto as it is advantageous in achieving the object of the present disclosure.

[Equation 1]

$$\text{Swelling ratio} = W2/W1 \times 100$$

W2 is a weight measured after immersed in the electrolyte, and W1 is a weight measured before immersed in the electrolyte.

In this case, the swelling ratio may be measured according to the measurement method of the examples described below. The electrolyte may be obtained by mixing ethylene carbonate, ethyl methyl carbonate, and dimethyl carbonate in a volume ratio of 3:5:2.

The particulate organic binder may be applied to the adhesive layer in an amount of 0.05 to 1.0 $g/m^2$, 0.1 to 0.8 $g/m^2$, 0.1 to 0.5 $g/m^2$, 0.1 to 0.4 $g/m^2$, or 0.1 to 0.3 $g/m^2$, but the embodiment is not limited thereto.

An average particle diameter (D50) of the particulate organic binder may be 300 nm or more, 700 nm or less, or a value between the above numerical values. For example, the average particle diameter of the particulate organic binder may be 300 to 700 nm, 400 to 600 nm, 450 to 550 nm, 450 to 520 nm, or a value between the above numerical values. Within the above range, the pores of the porous separator may be prevented from being clogged, and electrode adhesive strength may be more easily exhibited, which is more preferable.

Although the particulate organic binder has been described by way of example, when the glass transition temperature is satisfied and blocking does not occur when evaluated by the method described in the evaluation method of the present disclosure, the type of the binder is not limited. For example, in addition to the acrylic-based polymer, a fluorine-based polymer or a copolymer thereof may be used, and the present disclosure is not limited thereto.

[Method of Manufacturing Composite Separator]

Hereinafter, a method of manufacturing a composite separator of the present disclosure will be described.

A method of manufacturing a composite separator for a secondary battery according to an embodiment of the present disclosure includes applying an aqueous dispersion containing a particulate organic binder onto one surface or both surfaces of a porous separator and drying the applied dispersion to form an adhesive layer.

In addition, the method of manufacturing a composite separator for a secondary battery according to an embodiment of the present disclosure includes: a) applying a slurry containing inorganic particles and a binder onto one surface or both surfaces of a porous substrate and drying the applied slurry to form a porous ceramic layer; and b) applying an aqueous dispersion containing a particulate organic binder onto one surface or both surfaces of a ceramic coated separator on which the porous ceramic layer is formed and drying the applied dispersion to form an adhesive layer.

Each component is the same as described above.

The slurry for forming the porous ceramic layer may be an aqueous slurry that uses water as a dispersion medium.

The dispersion for forming the adhesive layer may use water as a dispersion medium. The particulate organic binder may be provided in the form of particles dispersed in water through emulsion or suspension polymerization.

As the coating method, any common method known in the related art may be applied without limitation, and non-limiting examples thereof include roll coating, spin coating, dip coating, bar coating, die coating, slit coating, inkjet printing, and a combination of these methods.

The drying step is not particularly limited, and a drying temperature may be 100°C or lower, and may be, for example, 30 to 100°C or 40 to 100°C. When the drying is performed at the above temperature, the coating layer may be dried uniformly without deteriorating the physical structure of the porous substrate, thereby preventing coating defects.

In addition, the method may include, after the drying, winding the composite separator into a roll and storing and transporting the wound separator.

[Lithium Secondary Battery]

Still another aspect of the present disclosure provides a lithium secondary battery including the composite separator for a secondary battery described above. The lithium secondary battery may be manufactured by including the composite separator for a secondary battery according to an embodiment of the present disclosure, a positive electrode, a negative electrode, and a non-aqueous electrolyte.

In an embodiment, the lithium secondary battery is manufactured by a general manufacturing method of arranging and assembling a negative electrode, a composite separator, and a positive electrode, and injecting an electrolyte. Therefore, the manufacturing method will not be described in detail herein.

In this case, the positive electrode, negative electrode, and non-aqueous electrolyte may be used without limitation as long as they are generally used in a lithium secondary battery.

In an embodiment, the positive electrode and negative electrode may be manufactured by mixing and stirring a positive electrode active material and a negative electrode active material with a solvent, and as necessary, a binder, a conductive agent, a dispersant, and the other necessary materials to prepare compositions, applying the compositions to current collectors formed of metal materials, drying the applied compositions, and then performing pressing.

The positive electrode active material may be used as long as it is an active material commonly used in a positive electrode of a secondary battery. For example, lithium metal oxide particles containing one or two or more metals selected from the group consisting of Ni, Co, Mn, Na, Mg, Ca, Ti, V, Cr, Cu, Zn, Ge, Sr, Ag, Ba, Zr, Nb, Mo, Al, Ga, B, and a combination thereof may be used.

The negative electrode active material may be used as long as it is an active material commonly used in a negative electrode of a secondary battery. The negative electrode active material of the lithium secondary battery is preferably a material capable of lithium intercalation. As a non-limiting example, the negative electrode active material may be one or two or more materials selected from the group consisting of negative electrode active materials such as lithium (metal lithium), soft carbon, hard carbon, graphite, silicon, a Sn alloy, a Si alloy, a Sn oxide, a Si oxide, a Ti oxide, a Ni oxide, an Fe oxide (FeO), and lithium-titanium oxide ($LiTiO_2$ and $Li_4Ti_5O_{12}$).

As the conductive agent, a conductive carbon material may be used without particular limitation.

The non-aqueous electrolyte contains a lithium salt as an electrolyte and an organic solvent, and the lithium salt may be used without limitation as long as it is used in an electrolyte for a lithium secondary battery and may be represented by $Li^+X^-$.

An anion of the lithium salt is not particularly limited, and one or two or more selected from $F^-$, $Cl^-$, $Br^-$, $I^-$, $NO_3^-$, $N(CN)_2^-$, $BF_4^-$, $ClO_4^-$, $PF_6^-$, $(CF_3)_2PF_4^-$, $(CF_3)_3PF_3^-$, $(CF_3)_4PF_2^-$, $(CF_3)_5PF^-$, $(CF_3)_6P^-$, $CF_3SO_3^-$, $CF_3CF_2SO_3^-$, $(CF_3SO_2)_2N^-$, $(FSO_2)_2N^-$, $CF_3CF_2(CF_3)_2CO^-$, $(CF_3SO_2)_2CH^-$, $(SF_5)_3C^-$, $(CF_3SO_2)_3C^-$, $CF_3(CF_2)_7SO_3^-$, $CF_3CO_2^-$, $CH_3CO_2^-$, $SCN^-$, and $(CF_3CF_2SO_2)_2N^-$ may be used.

As the organic solvent, one or a mixture of two or more selected from the group consisting of propylene carbonate, ethylene carbonate, diethyl carbonate, dimethyl carbonate, ethylmethyl carbonate, methylpropyl carbonate, dipropyl carbonate, dimethyl sulfoxide, acetonitrile, dimethoxyethane, diethoxyethane, sulfolane, $\gamma$-butyrolactone, and tetrahydrofuran may be used.

The non-aqueous electrolyte may be injected into an electrode structure composed of a positive electrode, a negative electrode, and a composite separator interposed between the positive electrode and the negative electrode.

An outer shape of the lithium secondary battery is not particularly limited, and may be selected from a cylindrical shape using a can, a square shape, a pouch shape, a coin shape, and the like.

Hereinabove, although the embodiments of the present disclosure have been described in detail, it will be apparent to those skilled in the art to which the present disclosure pertains that the embodiments may be variously modified without departing from the scope of the present disclosure. Therefore, such changes in the embodiments of the present disclosure fall within the scope of the present disclosure. Furthermore, the embodiments may be combined to form additional embodiments.

Hereinafter, examples of the present disclosure will be further described with reference to specific experimental examples. The examples and comparative examples included in the experimental examples are merely illustrative of the present disclosure and do not limit the scope of the of the accompanying claims, and it is obvious to those skilled in the art that various modifications and alterations may be made without departing from the scope of the present disclosure, and it is obvious that these modifications and alterations are within the accompanying claims.

1. Adhesive Strength to Positive Electrode

An adhesive layer of a composite separator was stacked on a surface of the following positive electrode so that the adhesive layer and the positive electrode were brought into contact with each other and then bonded by pressing at 80°C and 20 MPa for 30 seconds using a heat press. The electrode adhesive strength was measured by peeling the adhesive layer at 180° using UTM equipment (product name: Instron 3365) available from INSTRON according to ASTM D 903. When it was impossible to peel the adhesive layer using the UTM equipment since the adhesive strength of the adhesive layer of the composite separator was too low, it was evaluated as "unmeasurable".

Manufacture of positive electrode: A positive electrode slurry was prepared by adding 94 wt% of lithium-cobalt composite oxide ($LiCoO_2$) as a positive electrode active material, 3.5 wt% of carbon black as a conductive agent, and 2.5 wt% of polyvinylidene fluoride (PVdF) as a binder to N-methyl-2 pyrrolidone (NMP) as a solvent. The prepared slurry was applied to an aluminum (Al) thin film having a thickness of 30 pm, drying the applied slurry at a temperature of 120°C, and then performing roll-press, thereby manufacturing a positive electrode having a thickness of 150 $\mu$m.

2. Evaluation of Electrode Adhesion

The electrodes were cut into pieces of 4 cm in width and 6 cm in length, the four cut positive electrodes and four cut negative electrodes were alternately stacked on a surface of the composite separator, bonded at 80°C at 0.980665 $N/mm^2$ (10 kgf/cm ) for 30 seconds, and taken off, and then, the number of electrodes adhering to the composite separator was evaluated.

A: All 8 electrodes (4 anodes and 4 cathodes) remained adhered, B: 6 or 7 electrodes remained adhered, C: 4 or 5 electrodes remained adhered, D: fewer than 4 electrodes remained adhered

The positive electrode and negative electrode used in the evaluation were manufactured as follows.

Manufacture of positive electrode: A positive electrode slurry was prepared by adding 94 wt% of lithium-cobalt composite oxide ($LiCoO_2$) as a positive electrode active material, 3.5 wt% of carbon black as a conductive agent, and 2.5 wt% of polyvinylidene fluoride (PVdF) as a binder to N-methyl-2 pyrrolidone (NMP) as a solvent. The prepared slurry was applied to an aluminum (Al) thin film having a thickness of 30 pm, drying the applied slurry at a temperature of 120°C, and then performing roll-press, thereby manufacturing a positive electrode having a thickness of 150 $\mu$m.

Manufacture of negative electrode: A negative electrode mixed slurry was prepared by adding 95 wt% of artificial graphite, 3 wt% of a binder (acrylic-based latex having a Tg of -52°C), and 2 wt% of a thickener (carboxymethyl cellulose (CMC)) to water as a solvent. The prepared slurry was applied to a copper (Cu) thin film having a thickness of 20 pm, drying the applied slurry at a temperature of 120°C, and then performing roll-press, thereby manufacturing a negative electrode having a thickness of 150 $\mu$m.

3. Evaluation of Blocking

Two samples were prepared, the adhesive layers were brought into contact with each other, pressurized at a temperature of 50°C and a pressure of 1.7 MPa for 2 hours, and then peeled at a speed of 300 mm/min and 180°, and whether peeling of the coating layer between the adhesive layers occurred was evaluated. The occurrence of peeling of the coating layer in a $50 \times 50$ $\mu$m area was evaluated by observation with the naked eye and SEM.

PASS: When observing with the naked eye and confirming five random $50 \times 50$ $\mu$m areas over the entire area of the sample with SEM, no peeling of the coating layer occurs at all.

OK: When observing with the naked eye, no peeling of the coating layer is observed, and when confirming five random $50 \times 50$ $\mu$m areas over the entire area of the sample with SEM, less than 2% of the area of coating layer peeling is observed.

Fail: Even when observing with the naked eye, peeling of the coating layer is observed, or when confirming five random $50 \times 50$ $\mu$m areas over the entire area of the sample with SEM, 2% or more of the area of coating layer peeling is observed.

4. Thermal Shrinkage

After leaving a composite separator with a size of 10 cm $\times$ 10 cm at 150°C for 1 hour, a rate of decrease in area was measured and a thermal shrinkage was calculated in both a machine direction and a width direction according to the following equation.

Thermal shrinkage (%) = ((Length before heating - Length after heating)/Length before heating) $\times$ 100

5. Battery Lifespan Discharge Capacity Ratio Compared to Initial Capacity

A pouch-type battery was assembled using the same stacking method as in the evaluation of the electrode adhesion, each assembled battery was subjected to heat pressing at 80°C and 0.980665 N/mm$^2$ (10 kgf/cm$^2$) for 30 seconds before electrolyte injection, and an electrolyte obtained by mixing ethylene carbonate (EC), ethyl methyl carbonate (EMC), and dimethyl carbonate (DMC) in a volume ratio of 3:5:2 and containing 1 M lithium hexafluorophosphate (LiPF$_6$) dissolved therein was injected, thereby manufacturing a lithium secondary battery.

Each of the manufactured batteries was subjected to a cycle evaluation by charging and discharging the battery 300 times at a discharge rate of 1 C, and then measuring a discharge capacity to measure a degree of decrease in capacity compared to an initial capacity.

Discharge capacity ratio = (Battery capacity measured after 300 cycles)/Initial battery capacity (1.8 Ah)

6. Method of Measuring Average Particle Diameter

An average particle diameter D50 for the inorganic particles and the particulate binder was measured using a particle size analyzer, S3500 available from Microtrac Retsch GmbH, according to the ISO 13320-1 standard.

7. Method of Measuring Glass Transition Temperature

Analysis was performed by a differential scanning calorimeter (DSC) (DSC-822E available from Mettler Toledo). As analysis conditions, the solvent was removed, 5 mg of a solidified sample was heated from -50°C to 200°C at a scanning rate of 10 °C/min under nitrogen conditions to completely melt the sample, cooled at 10 °C/min to solidify the sample, and heated again at 10 °C/min in a range of -50°C to 200°C, and then, a glass transition temperature was measured.

The glass transition temperature of the particulate organic binder was measured as follows. For example, the glass transition temperature of the core-shell particulate organic binder was measured as follows. First, the core polymer was synthesized, and the glass transition temperature (Tg) was measured by measuring the Tg of the core alone.

Afterward, the core-shell particles were prepared, and the Tg of the entire particles was measured.

8. Rate of Change in Weight During Electrolyte Immersion (Swelling Ratio)

An aqueous dispersion containing organic particles for forming an adhesive layer was placed in a Teflon Petri dish, water was evaporated at 60°C for one day to form a film and the weight of the film was measured. Thereafter, 1 g of the film was immersed in an electrolyte obtained by mixing ethylene carbonate, ethyl methyl carbonate, and dimethyl carbonate in a volume ratio of 3:5:2 and left at 50°C for 48 hours, the electrolyte was drained, and then, a weight of the film was measured to calculate a rate of change in weight.

$$\mathtt{Swelling\ Ratio\ =\ \ W2/W1\ \times\ 100}$$

W2 is a weight measured after immersed in the electrolyte, and W1 is a weight measured before immersed in the electrolyte. A unit of the swelling ratio is %.

9. Average Thickness (pm)

An average thickness of the separator was determined by the following method. The separators were stacked in 10 layers, thicknesses were measured at five random points selected along a width direction using a thickness gauge available from Mitutoyo Corporation, and the measured thicknesses were added up and divided by 5 to derive an average thickness of the 10 layers of the separators and then divided again by 10 to derive an average thickness of the entire single separator.

Only the porous substrates were stacked in 10 layers, thicknesses were measured at five random points selected along a width direction using the thickness gauge available from Mitutoyo Corporation, and the measured thicknesses were added up and divided by 5 to derive an average thickness of the 10 layers of the porous substrates and then divided again by 10 to derive an average thickness of the porous substrates. In the case where the inorganic particle layer was formed, the inorganic particle layer was detached and sufficient drying was performed, and then the average thickness of the porous substrate from which the inorganic particle layer was detached was derived using the same method described above.

10. Gurley Permeability (sec/100 cc)

A gurley permeability was measured using a densometer available from Toyo Seiki Seisaku-sho, Ltd. according to ASTM D726 standard. The times taken for 100 cc of air to pass through an area of 1 square inch of the separator were recorded in seconds and compared with each other.

[Example 1]

1) Manufacture of porous separator coated with porous ceramic layer

The following slurry for an inorganic particle layer was coated with bar-coater at a speed of 5 m/min onto both surfaces of a polyethylene porous substrate (ENPASS available SK Innovation Co., Ltd.) having a Gurley permeability of 126 sec/100 cc and a thickness of 9 $\mu$m to form a coating layer, and the coating layer was sufficiently dried at 40°C to form a porous ceramic layer. After drying, a coating thickness of the porous ceramic layer formed on each of both surfaces was 1.5 $\mu$m.

The slurry for an inorganic particle layer was mixed with 29.1 wt% of boehmite particles having an average particle diameter ($D_{50}$) of 300 nm and 67.9 wt% of boehmite particles having an average particle diameter ($D_{50}$) of 700 nm as inorganic particles, and 3 wt% of a polyacrylamide resin, and water as a solvent was added and stirred, thereby preparing a composition having a solid content concentration of 25 wt%.

2) Manufacture of Composite Separator

A coating solution for an adhesive layer was coated with bar-coater at a speed of 5 m/min on both surfaces of the manufactured ceramic coated separator to form an adhesive layer, and the adhesive layer was dried sufficiently at 40°C and then wound into a roll shape. A thickness of the adhesive coating layer formed on each of both surfaces was 0.5 $\mu$m, and a coating amount on each of both surfaces was 0.2 g/m$^2$.

As the coating solution for an adhesive layer, a polymer particle dispersion (D50: 0.5 pm, Tg: 77.4°C, acrylic-based particles having a core-shell structure prepared using butyl methacrylate, methyl methacrylate, acrylonitrile, and styrene monomers) was used.

The physical properties of the manufactured composite separator were evaluated. The results are shown in Table 2.

[Examples 2 to 5]

Composite separators were manufactured in the same manner as that of Example 1, except that the physical properties of the core-shell particles were changed as shown in Table 1.

The physical properties of the manufactured composite separator were evaluated. The results are shown in Table 2.

[Comparative Examples 1 to 3]

Composite separators were manufactured in the same manner as that of Example 1, except that the physical properties of the core-shell particles were changed by controlling the contents of the monomers as shown in Table 1.

The physical properties of the manufactured composite separator were evaluated. The results are shown in Table 2.

[Table 1]

| | Glass transition temperature of core-shell particle (°C) | Glass transition temperature of core (°C) | Average particle diameter D50 ($\mu$m) | Coating amount (g/m$^2$) | Swelling ratio (%) |
|---|---|---|---|---|---|
| Example 1 | 77 | 65 | 0.5 | 0.2 | 380 |
| Example 2 | 60 | 50 | 0.51 | 0.2 | 450 |
| Example 3 | 80 | 70 | 0.48 | 0.2 | 320 |
| Example 4 | 65 | 60 | 0.5 | 0.4 | 490 |
| Example 5 | 69 | 62 | 0.52 | 0.1 | 450 |
| Comparative Example 1 | 91 | 85 | 0.55 | 0.2 | 300 |
| Comparative Example 2 | 82 | 68 | 0.45 | 0.2 | 550 |
| Comparative Example 3 | 55 | 60 | 0.51 | 0.2 | 680 |

(Coating amount: Weight of coating layer per unit area of separator)

[Table 2]

| | Electrode adhesive strength (gf/cm) * | Electrode adhesion | Blocking evaluation | Thermal shrinkage at 150°C MD/TD (%) | Capacity retention rate after 300 cycles (%) |
|---|---|---|---|---|---|
| Example 1 | 5.8 | A | PASS | 1.5/1.5 | 97 |
| Example 2 | 7.2 | A | PASS | 1.3/1.4 | 94 |
| Example 3 | 5.2 | A | PASS | 0.9/1.2 | 93 |
| Example 4 | 10.2 | A | PASS | 1.1/0.9 | 92 |
| Example 5 | 8.7 | A | PASS | 1.3/1.3 | 95 |
| Comparative Example 1 | 3.2 | D | Fail | 0.5/0.7 | 83 |
| Comparative Example 2 | 4.6 | C | Fail | 1.5/1.5 | 80 |
| Comparative Example 3 | 6.3 | A | Fail | 1.4/1.4 | 79 |
| *the unit of 1 gram-force (gr)/cm is approximately equal to 0.000980665 Newtons (N)/mm | | | | | |

As shown in Tables 1 and 2, in the examples of the present disclosure, it was found that, when a particulate organic binder satisfying the glass transition temperature and the swelling ratio was used, the electrode adhesive strength was excellent, no blocking occurred at all in the blocking evaluation, no electrode detachment occurred at all in the electrode adhesion evaluation, and the capacity retention rate after 300 cycles was significantly excellent, i.e. more than 90% and even 92 % or more. In addition, it was observed that, when the composite separator in the examples was manufactured, wound, and stored, a composite separator having excellent anti-blocking properties was provided without the occurrence of blocking between the adhesive layers, between the adhesive layer and the ceramic layer, or between the adhesive layer and the porous substrate, of the wound roll, even when stored at a high temperature of 50 to 70°C as well as at room temperature.

However, as in Comparative Examples 1 and 2, in the case where a particulate organic binder that does not satisfy the glass transition temperature of the present disclosure was used, it was observed that the electrode adhesive strength was low, electrode detachment occurred in the electrode adhesion evaluation, and blocking occurred in the blocking evaluation.

In addition, as in Comparative Example 3, in the case where the glass transition temperature of the whole core-shell particle was lower than the glass transition temperature of the core, it was found that the electrode adhesive strength was satisfied, but severe blocking occurred in the blocking evaluation. In addition, it was found that the capacity retention rate was significantly low.

Therefore, the electrode adhesion and the blocking properties were not accurately predicted with the electrode adhesive strength by the method according to the related art, but as in the present disclosure, when a particulate organic binder was used, the glass transition temperature of the particulate organic binder was satisfied, and the adhesive strength was also satisfied, it was confirmed that the blocking properties, the electrode adhesion, and the capacity retention rate were all satisfied. In addition, it was observed that the blocking properties and the battery capacity were not satisfied even when the electrode adhesive strength was satisfied without satisfying the glass transition temperature, and from this, it was found that the occurrence of blocking was not predicted only by evaluating the electrode adhesion according to the related art, which well proved the effects of the present disclosure.

As set forth above, the composite separator according to an embodiment of the present disclosure has the excellent adhesive strength to the electrode, and may prevent the occurrence of blocking that occurs during winding.

Another aspect of the present disclosure may provide the composite separator that may not cause a phenomenon in which a coating layer is peeled due to blocking even when exposed to a high temperature during storage and transport of a wound separator.

Specifically, it is possible to provide a composite separator having excellent anti-blocking properties, which does not cause blocking between adhesive layers, between an adhesive layer and a ceramic layer, or between an adhesive layer and a porous substrate, of a wound roll, even when stored at a high temperature of 50 to 70°C as well as at room temperature of about 25°C during transport and storage of a wound separator.

Further, it is possible to provide a composite separator that does not cause blocking when adhesive layers of the separator of the present disclosure are brought into contact with each other, pressurized at a temperature of 50°C and a pressure of 1.7 MPa for 2 hours, and then peeled at a speed of 300 mm/min and an angle of 180°.

Further, it is possible to provide a composite separator having small thermal shrinkage and excellent battery stability.

Further, it is possible to provide a composite separator that has an excellent adhesive strength to an electrode because a change in adhesive strength is small when wound and then unwound and then used.

Further, it is possible to provide a battery that has excellent alignment between electrodes and a separator during cell stacking, may prevent misalignment during a process, and has a uniform thickness deviation.

Further, it is possible to provide a battery that may provide uniform lithium ion conductivity over the entire area of a separator and may maintain a capacity retention rate of 90% or more or 95% or more after 300 cycles compared to an initial capacity.

The content described above is merely an example of applying the principles of the present disclosure, and other configurations may be further included without departing from the scope of the present disclosure.

Hereinabove, although the present disclosure has been described by specific matters and limited examples and comparative examples, they have been provided only for assisting in the entire understanding of the present disclosure. Therefore, the present disclosure is not limited to the examples. Various modifications and changes may be made by those skilled in the art to which the present disclosure pertains from this description.

[Detailed Description of Main Elements]

100: Composite separator

110: Porous separator
120: Adhesive layer

**Claims**

1. A composite separator comprising an adhesive layer formed on the outermost layer of at least one surface of a porous separator,

 wherein the adhesive layer comprises a particulate organic binder, and
 when the adhesive layers are brought into contact with each other, pressurized at a temperature of 50°C and a pressure of 1.7 MPa for 2 hours, and then peeled at a speed of 300 mm/min and an angle of 180°, blocking does not occur between the adhesive layers, and an adhesive strength to a positive electrode is about 0.0049 N/mm or more (5 gf/cm or more).

2. The composite separator of claim 1, wherein a content of the particulate organic binder in the adhesive layer is 0.1 to 0.5 g/m$^2$, and/or
 wherein an average particle diameter of the particulate organic binder is 400 to 600 nm.

3. The composite separator of claim 1 or 2, wherein the porous separator includes a porous substrate or a porous substrate and a porous ceramic layer containing inorganic particles and being formed on one surface or both surfaces of a porous substrate.

4. The composite separator of any one of claims 1 to 3, wherein the particulate organic binder is a core-shell particulate organic binder.

5. The composite separator of claim 4, wherein the core-shell particulate organic binder has a glass transition temperature of a whole core-shell particle that is higher than a glass transition temperature of a core.

6. The composite separator of claim 4 or 5, wherein the glass transition temperature of the core of the core-shell particulate organic binder is 50 to 75°C.

7. The composite separator of any one of claims 4 to 6, wherein the glass transition temperature of the whole core-shell particle of the core-shell particulate organic binder is 60 to 80°C.

8. The composite separator of any one of claims 4 to 7, wherein the core-shell particulate organic binder is a particulate acrylic-based organic binder, and the shell comprises a structure derived from an aromatic vinyl monomer.

9. The composite separator of any one of claims 1 to 8, wherein when electrodes are cut into pieces of 4 cm in width and 6 cm in length, and the four cut positive electrodes and four cut negative electrodes are alternately stacked on a surface of the composite separator, bonded at 80°C at 0.980665 N/mm$^2$ (10 kgf/cm$^2$) for 30 seconds, and then unfolded, all of the electrodes are not detached;
 and/or wherein the composite separator has a thermal shrinkage of 3% or less in both a machine direction and a width direction when measured at 150°C.

10. The composite separator of any one of claims 3 to 9, wherein the inorganic particles of the porous ceramic layer have an average particle diameter of 50 nm to 2 $\mu$m.

11. The composite separator of any one of claims 3 to 10, wherein the inorganic particles of the porous ceramic layer include first inorganic particles having an average particle diameter of 50 nm to 500 nm and second inorganic particles having an average particle diameter of 500 nm to 2,000 nm; and/or wherein the porous ceramic layer has pores formed between the inorganic particles connected by the binder.

12. The composite separator of any one of claims 3 to 11, wherein the porous substrate is a polyolefin-based porous film.

13. A lithium secondary battery comprising the composite separator of any one of claims 1 to 12.

14. The lithium secondary battery of claim 13, wherein when a cycle evaluation is performed by charging and discharging the lithium secondary battery 300 times at a discharge rate of 1 C and then measuring a discharge capacity to determine a degree of decrease in capacity compared to an initial capacity, a discharge capacity ratio calculated by the following equation is 90% or more:

Discharge capacity ratio = (Battery capacity measured after 300 cycles)/Initial battery capacity.

15. Use of a composite separator according to any one of claims 1 to 13 for winding thereof into a roll and optional subsequent storage and/or transport of the wound separator;
optionally using the composite separator for manufacturing a secondary battery.

FIG. 1

FIG. 2

FIG. 3

SKI-AL-LAB 5.0kV 12.8mm x1.00k 12/18/2023          50.0um

FIG. 4

SKI-ASC-OP 5.0kV 8.9mm x1.00k SE(M) 12/4/2024          50.0um

Europäisches
Patentamt

European
Patent Office

Office européen
des brevets

## EUROPEAN SEARCH REPORT

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2015 028842 A (NIPPON ZEON CO) 12 February 2015 (2015-02-12) * paragraphs [0017] - [0054], [0109] * * claims 1,2,5 * | 1-9, 12-15 | INV. H01M10/052 H01M50/417 H01M50/446 H01M50/451 |
| X | US 11 183 736 B2 (SK INNOVATION CO LTD [KR]; SK IE TECH CO LTD [KR]) 23 November 2021 (2021-11-23) * column 1, lines 15-19 * * column 2, lines 3-30 * * column 5, lines 13-15 * * examples 1,3 * * column 17, lines 34-44 * * claim 1 * | 1,3,4,6, 8,10-15 | H01M50/46 H01M50/489 |

TECHNICAL FIELDS
SEARCHED      (IPC)

H01M

The present search report has been drawn up for all claims

| Place of search | Date of completion of the search | Examiner |
|---|---|---|
| The Hague | 15 April 2025 | Knoflacher, Andreas |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 22 1490

This annex lists the patent family members relating to the patent documents cited in the above-mentioned European search report.
The members are as contained in the European Patent Office EDP file on
The European Patent Office is in no way liable for these particulars which are merely given for the purpose of information.

15-04-2025

| Patent document cited in search report | | Publication date | Patent family member(s) | | Publication date |
|---|---|---|---|---|---|
| JP 2015028842 | A | 12-02-2015 | NONE | | |
| US 11183736 | B2 | 23-11-2021 | CN | 110676418 A | 10-01-2020 |
| | | | EP | 3591736 A1 | 08-01-2020 |
| | | | KR | 20200003486 A | 10-01-2020 |
| | | | US | 2020006733 A1 | 02-01-2020 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4414165 B